# FASCICULE DE BREVET EUROPEEN

(11) **EP 3 175 250 B1**
(45) Date de publication et mention de la délivrance du brevet: **04.12.2019**
(21) Numéro de dépôt: 15742272.6
(22) Date de dépôt: 27.07.2015
(51) Int. Cl.: G01R 31/12

(54) **DISPOSITIF DE DETECTION DE DECHARGE PARTIELLE DE MATERIEL HAUTE TENSION ISOLE AU GAZ ET POSTE ELECTRIQUE HAUTE TENSION ASSOCIE**
VORRICHTUNG ZUR ERKENNUNG EINER PARTIELLEN ENTLADUNG AUS EINER GASISOLIERTEN HOCHSPANNUNGSANLAGE UND ZUGEHÖRIGE ELEKTRISCHE HOCHSPANNUNGSUNTERSTATION
DEVICE FOR DETECTING A PARTIAL DISCHARGE FROM GAS-INSULATED HIGH-VOLTAGE EQUIPMENT, AND ASSOCIATED HIGH-VOLTAGE ELECTRICAL SUBSTATION

(30) Priorité: 28.07.2014 FR 1457296
(43) Date de publication de la demande: 07.06.2017
(73) Titulaire: General Electric Technology GmbH, 5400 Baden (CH)
(72) Inventeur: VUACHET, Jacques, F-74330 Poisy (FR); MAUFFREY, Thibaut, F-74000 Annecy (FR)
(74) Mandataire: Brevalex
(86) Numéro de dépôt international: PCT/EP2015/067178
(87) Numéro de publication internationale: WO 2016/016199

(56) Documents cités:
- CN-A- 1 114 418
- CN-A- 102 520 322
- CN-U- 202 421 426

## Description

### Domaine technique et art antérieur

L'invention concerne un dispositif de détection de décharge partielle de matériel haute tension isolé au gaz ainsi qu'un poste électrique haute tension isolé au gaz équipé d'un dispositif de détection de décharge partielle de l'invention.

Le dispositif de détection de décharge partielle de l'invention est de type externe, positionné en surface du matériel haute tension isolé au gaz (GIS en langue anglaise pour « Gaz Insulated System »).

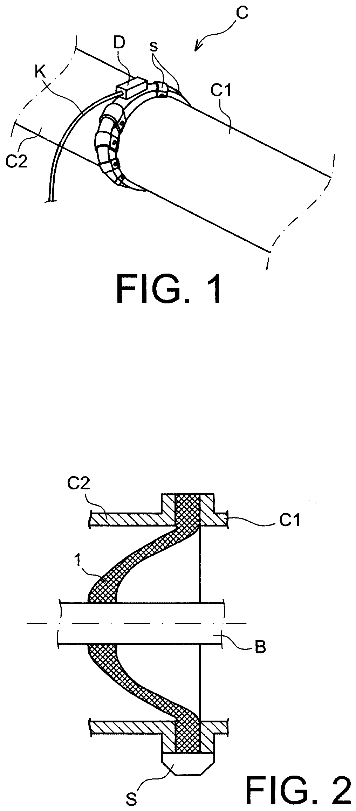

Les documents CN 102 520 322 A, CN 202 421 426 U et CN 1 114 418 A divulguent des dispositifs de détection de décharge partielle de l'art antérieur. La figure 1 représente une vue en perspective d'un matériel haute tension isolé au gaz équipé d'un dispositif de détection de décharge partielle de type externe de l'art antérieur et la figure 2 représente une vue en coupe longitudinale du matériel haute tension représenté en figure 1.

Le matériel haute tension isolé au gaz comprend un corps métallique creux C de forme cylindrique formé de deux parties cylindriques C1, C2 fixées l'une à l'autre via la base d'une pièce électriquement isolante 1 en forme de cône. La pièce électriquement isolante 1 assure le maintien d'une barre haute tension B à l'intérieur du corps métallique C. Des shunts S relient électriquement les deux parties cylindriques C1 et C2. La base de la pièce électriquement isolante 1 est insérée entre les parties cylindriques C1 et C2. Cette base présente une face qui définit, en surface du matériel haute tension, un cylindre de révolution. C'est sur cette face que le dispositif de détection de décharge partielle D est positionné.

Le dispositif D prélève les signaux de décharge partielle via un élément d'antenne (non représenté sur la figure 1). Un câble électrique K est relié au dispositif D pour prélever le signal détecté.

Le dispositif D est lourd et de volume encombrant. Cet encombrement conditionne le positionnement du dispositif sur la pièce électriquement isolante. Or, des décharges partielles peuvent survenir en n'importe quel endroit du matériel. Il est alors possible que l'emplacement du dispositif ne soit pas adapté pour détecter correctement les décharges partielles.

Le dispositif de détection de décharge partielle de l'invention ne présente pas les inconvénients mentionnés ci-dessus.

### Exposé de l'invention

L'invention concerne un dispositif de détection de décharge partielle de matériel haute tension isolé au gaz, le dispositif étant fixé, à l'extérieur du matériel haute tension, sur une face d'une pièce électriquement isolante qui assure le maintien d'une barre haute tension à l'intérieur du matériel haute tension, ladite face définissant, en surface du matériel haute tension, un cylindre de révolution, caractérisé en ce qu'il comprend :
- une bande électriquement conductrice fixée sur une bande de matériau électriquement isolant, la bande électriquement conductrice étant enroulée au contact exclusif de tout ou partie de ladite face, et
- une pièce de blindage électrique fixée sur le matériel haute tension et qui est positionnée au-dessus de la bande de matériau électriquement isolant.

De façon avantageuse, la bande électriquement conductrice fixée sur la bande de matériau électriquement isolant est peu encombrante et peut être positionnée sans contrainte particulière sur tout ou partie de la face de la pièce électriquement isolante.

Dans un premier mode de réalisation de l'invention, la bande électriquement conductrice est une bande pleine présentant ou non des motifs aptes à privilégier la détection de fréquences particulières prédéterminées.

Dans un deuxième mode de réalisation de l'invention, la bande électriquement conductrice comprend au moins une fente pratiquée dans toute l'épaisseur de la bande électriquement conductrice, l'axe de la fente pratiquée dans la bande électriquement conductrice étant sensiblement parallèle à l'axe de la bande électriquement conductrice, la pièce de blindage électrique étant mise en contact électrique avec les bords latéraux de la bande électriquement conductrice. La bande électriquement conductrice constitue alors, en combinaison avec la pièce de blindage électrique, une antenne à fente(s).

Dans un troisième mode de réalisation de l'invention, la bande électriquement conductrice participe, avec la pièce de blindage métallique qui recouvre la bande de matériau électriquement isolant, à la formation d'une antenne à double fentes. Une fente de l'antenne à double fentes est alors formée, de part et d'autre de la bande électriquement conductrice, par l'espace qui sépare un bord de la bande électriquement conductrice d'un bord de la pièce de blindage électrique.

Dans tous les modes de réalisation de l'invention, des moyens mécaniques sont prévus pour maintenir la bande électriquement conductrice sur la face de la pièce électriquement isolante qui définit un cylindre de révolution en surface du matériel haute tension.

La bande électriquement conductrice et la bande de matériau électriquement isolant sont des bandes souples ou des bandes rigides. Dans un mode de réalisation particulier, la bande électriquement conductrice est une bande métallique.

L'invention concerne également un poste électrique haute tension isolé au gaz équipé d'au moins un dispositif de détection de décharge partielle conforme au dispositif de l'invention.

### Brève description des figures

D'autres caractéristiques et avantages de l'invention apparaîtront à la lecture de la description qui va suivre, faite en référence aux figures jointes, parmi lesquelles :
- La figure 1 représente une vue en perspective d'un matériel haute tension isolé au gaz équipé d'un dispositif de détection de décharge partielle de l'art antérieur ;
- La figure 2 représente une vue en coupe longitudinale du matériel haute tension représenté en figure 1 ;
- La figure 3 représente une vue en coupe transversale d'une première variante d'un dispositif de détection de décharge partielle selon le premier mode de réalisation de l'invention ;
- La figure 4 représente une vue en coupe transversale d'une deuxième variante d'un dispositif de détection de décharge partielle selon le premier mode de réalisation de l'invention ;
- La figure 5 représente une vue en coupe longitudinale du matériel haute tension équipé d'un dispositif de détection de décharge partielle selon la deuxième variante du premier mode de réalisation de l'invention ;
- La figure 6 représente une vue en coupe transversale d'une première variante d'un dispositif de connexion de dispositif de détection de décharge partielle conforme au premier mode de réalisation de l'invention ;
- La figure 7 représente une vue en coupe transversale d'une deuxième variante d'un dispositif de connexion de dispositif de détection de décharge partielle conforme au premier mode de réalisation de l'invention;
- La figure 8 représente une vue en coupe longitudinale du matériel haute tension équipé d'un dispositif de détection de décharge partielle muni d'un dispositif de connexion selon l'invention ;
- La figure 9A représente une vue en coupe longitudinale d'un dispositif de détection de décharge partielle de l'invention équipé d'une bride de maintien et la figure 9B représente une vue en perspective de la bride de maintien représentée sur la figure 9A ;
- Les figures 10A-10D représentent différents exemples de motifs d'antenne utilisés pour la réalisation d'un dispositif de détection de décharge partielle conforme au premier mode de réalisation de l'invention ;
- La figure 11 représente une vue en coupe longitudinale d'une troisième variante de dispositif de détection de décharge partielle conforme au premier mode de réalisation de l'invention ;
- Les figures 12A et 12B représentent des antennes à fente (s) qui participent à un dispositif de détection de décharge partielle conforme au deuxième mode de réalisation de l'invention ;
- Les figures 13A-13C représentent des vues en coupe transversale de différentes variantes d'antenne à fente(s) telle que représentée en figures 12A et 12B ;
- La figure 14 représente une vue en coupe d'un dispositif de connexion de dispositif de détection de décharge partielle conforme au deuxième mode de réalisation de l'invention ;
- La figure 15 représente une première vue en coupe d'une antenne à double fentes qui participe à un dispositif de détection de décharge partielle conforme au troisième mode de réalisation de l'invention ;
- La figure 16 représente une vue de dessus de l'antenne à double fentes représentée en figure 15 ;
- Les figures 17A et 17B représentent une deuxième vue en coupe de l'antenne à double fentes représentée en figure 15 ;
- La figure 18 représente une troisième vue en coupe de l'antenne à double fentes représentée en figure 15 ;
- La figure 19 représente un premier exemple de système d'attache de dispositif de détection de décharge partielle conforme à l'invention ;
- Les figures 20A et 20B représentent un deuxième exemple de système d'attache de dispositif de détection de décharge partielle conforme à l'invention ;
- Les figures 21A et 21B représentent un exemple de motif de blindage de dispositif de détection de décharge partielle conforme au premier mode de réalisation de l'invention ;
- La figure 22 représente un dispositif apte à former une antenne de dispositif de détection de décharge partielle conforme à l'invention.

Sur toutes les figures, les mêmes références désignent les mêmes éléments.

### Exposé détaillé de modes de réalisation particuliers

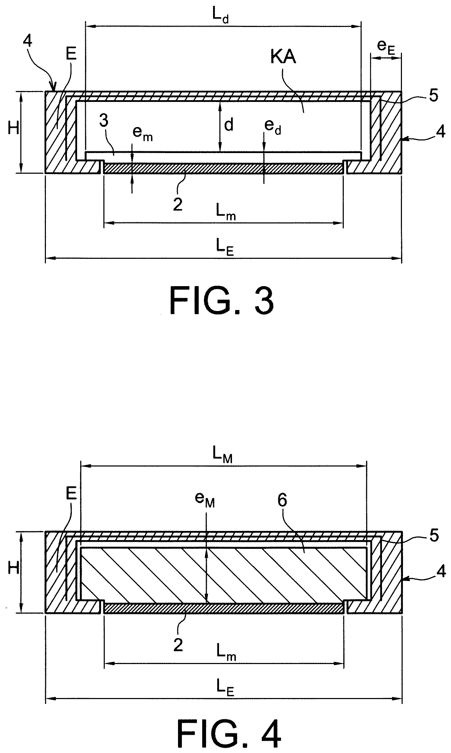

La figure 3 représente une vue en coupe transversale d'un dispositif de détection de décharge partielle selon une première variante du premier mode de réalisation de l'invention.

Le dispositif de détection de décharge partielle est constitué d'une bande électriquement conductrice 2 fixée sur une bande de matériau électriquement isolant 3 et d'une pièce de blindage électrique 5 qui recouvre, à distance, l'ensemble constitué par la bande électriquement conductrice 2 et la bande de matériau électriquement isolant 3. La pièce de blindage électrique 5 est moulée dans une pièce en élastomère E. La pièce en élastomère E et la pièce de blindage électrique 5 moulée dans la pièce en élastomère constitue une pièce mécanique 4. La pièce de blindage électrique 5 est faite d'une structure électriquement conductrice qui peut être souple ou non.

La largeur Lₘ de la bande électriquement conductrice 2 est inférieure à la largeur L_{d} de la bande de matériau électriquement isolant 3 de telle sorte que la face de la bande de matériau électriquement isolant sur laquelle est fixée la bande électriquement conductrice laisse apparaître des bords dépourvus de métallisation.

La pièce en élastomère E a la forme d'un parallélépipède rectangle creux qui définit une cavité KA. Une des quatre faces de la pièce E présente - sur toute sa longueur - une ouverture partielle. La largeur de l'ouverture est, d'une part, légèrement supérieure à la largeur Lₘ de la bande électriquement conductrice et, d'autre part, légèrement inférieure à la largeur de la bande de matériau électriquement isolant 3. La bande de matériau électriquement isolant 3 sur laquelle est fixée la bande électriquement conductrice 2 ferme cette ouverture. A cette fin, les bords dépourvus de métallisation de la bande de matériau électriquement isolant 3 prennent appui, à l'intérieur de la cavité KA, sur les bords de l'ouverture de la pièce en élastomère. Les bords de la bande de matériau électriquement isolant ne sont pas fixés sur les bords de la pièce en élastomère. Cette absence de fixation permet avantageusement d'éviter les contraintes de cisaillement lors du montage de l'ensemble constitué de la bande électriquement conductrice 2 fixée sur la bande 3 et de la pièce en élastomère E.

Afin de réaliser le dispositif de détection de décharge partielle de l'invention, la bande électriquement conductrice 2 est placée au contact de tout ou partie de la face de la pièce électriquement isolante 1 qui définit, en surface du matériel haute tension, un cylindre de révolution. Dans le mode de réalisation préférentiel de l'invention, la bande électriquement conductrice 2 est une bande souple qui épouse la totalité de la circonférence définie par la face de la pièce électriquement isolante 1.

A titre d'exemple non limitatif, les dimensions du dispositif de détection de décharge partielle de l'invention sont les suivantes :
- La largeur extérieure L_{E} de la pièce en élastomère E est comprise entre 50mm et 80mm ;
- La hauteur H de la pièce en élastomère E est égale à 16mm ;
- L'épaisseur eₘ de la bande électriquement conductrice 2 est égale à 2mm ;
- L'épaisseur e_{d} de la bande de matériau électriquement isolant 3 est égale à 2mm ;
- La distance d entre la bande de matériau électriquement isolant 3 et la paroi intérieure de la pièce en élastomère E qui fait face à cette couche diélectrique est égale 10mm ;
- L'épaisseur e_{E} des parois latérales de la pièce en élastomère E est égale à 6mm.

Le matériau qui constitue la couche diélectrique 3 est, par exemple, du mylar ou du polyuréthane et le métal de la couche métallique 2 est, par exemple, du cuivre.

Comme cela a été mentionné précédemment, la pièce 4 comprend une structure métallique 5 moulée dans une pièce en élastomère E. La structure métallique 5 a préférentiellement une section transversale en forme de U. La base du « U » définit une partie plane de la structure métallique qui fait face à la bande de matériau électriquement isolant 3 et les bras du « U », perpendiculaires à la base, sont positionnés dans les parois latérales de la pièce en élastomère E.

Sur la base des dimensions données précédemment, à titre d'exemple non limitatif, il apparaît que la distance qui sépare la bande électriquement conductrice 2 et la partie de la structure métallique 5 qui fait face à la bande de matériau électriquement isolant 3 est, par exemple, égale à 13mm. De façon avantageuse, la Demanderesse a constaté que l'éloignement de la structure métallique 5 de la bande électriquement conductrice 2, outre le fait d'éviter un couplage capacitif entre le blindage et la bande électriquement conductrice 2, permet d'augmenter de manière significative les performances de l'antenne dans le bas du spectre de détection.

La figure 4 représente une vue en coupe transversale d'un dispositif de détection de décharge partielle selon une deuxième variante du premier mode de réalisation de l'invention.

Selon la deuxième variante du premier mode de réalisation de l'invention, la bande de matériau électriquement isolant est une couche de mousse 6 de constante diélectrique relative proche de 1, par exemple, un éthylène-propylène-diène monomère.

La couche de mousse constitue, de façon avantageuse, un soutien mécanique souple pour la mise à distance de la pièce mécanique 4. La robustesse du dispositif s'en trouve accrue lors de l'installation de la bande sur la face de la pièce diélectrique ou lors d'un transport du dispositif. La présence de la couche de mousse permet également d'éviter que la cavité KA ne s'emplisse d'eau ou de poussière.

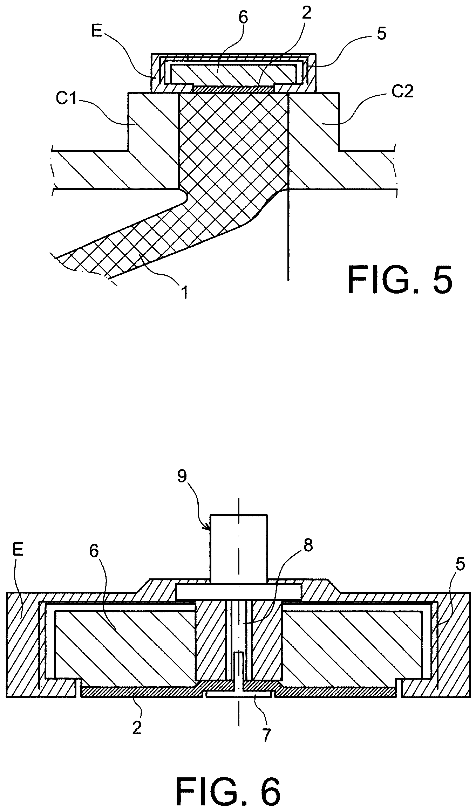

La figure 5 représente une vue en coupe longitudinale du matériel haute tension représenté en figure 2, équipé d'un dispositif de détection de décharge partielle selon la deuxième variante du premier mode de réalisation de l'invention.

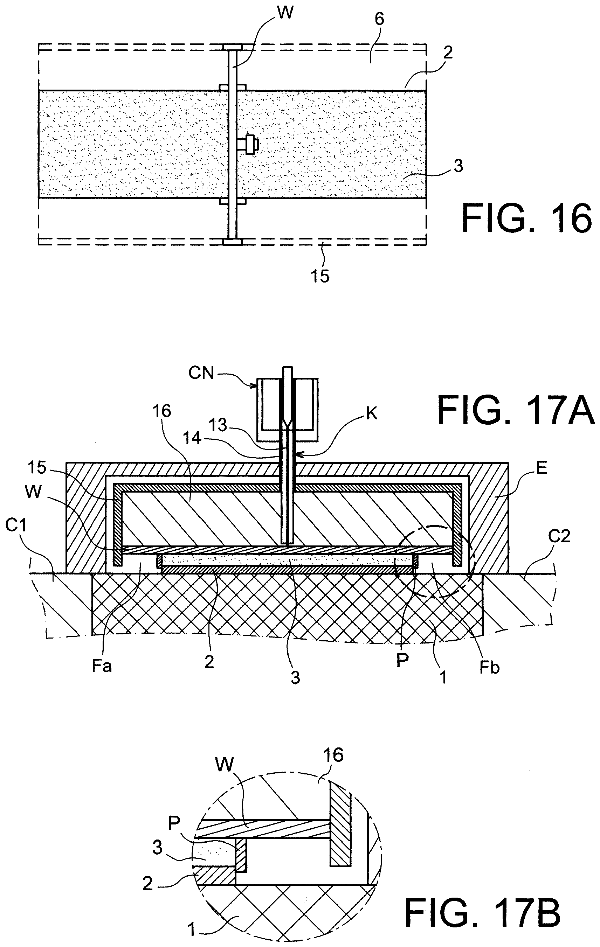

La bande électriquement conductrice 2 est positionnée en surface du matériel haute tension, au contact de la seule pièce électriquement isolante 1. De façon avantageuse, la bande électriquement conductrice 2 recouvre tout ou partie de la circonférence que définit la pièce électriquement isolante en surface du matériel haute tension. Dans le cas où la bande électriquement conductrice 2 est une bande souple qui recouvre la circonférence entière, la fixation du dispositif de détection de décharge partielle à la surface du matériel haute tension s'effectue, préférentiellement, par les moyens de fermeture détaillés en référence aux figures 16 et 17A-17B. Dans le cas où la bande électriquement conductrice 2 ne recouvre qu'une partie de la circonférence, la fixation du dispositif de détection s'effectue par tout moyen connu en soi, par exemple des sangles.

La figure 6 représente une vue en coupe transversale d'une première variante de dispositif de connexion de dispositif de détection de décharge partielle conforme à la deuxième variante du premier mode de réalisation de l'invention.

Un connecteur 9 est moulé dans l'élastomère E. Au niveau du connecteur, la mousse diélectrique 6 présente un trou débouchant qui est empli par une protubérance de la pièce en élastomère E et la protubérance de la pièce en élastomère E présente elle-même un trou débouchant dans lequel l'âme 8 du connecteur est placée. L'âme 8 du connecteur est électriquement reliée à une sonde de liaison 7 qui est en contact électrique avec la bande électriquement conductrice 2. L'âme 8 du connecteur est préférentiellement centrée par rapport à la bande électriquement conductrice 2. La structure métallique de blindage 5 est perforée au niveau du connecteur 9 afin de laisser passer la protubérance de la pièce en élastomère.

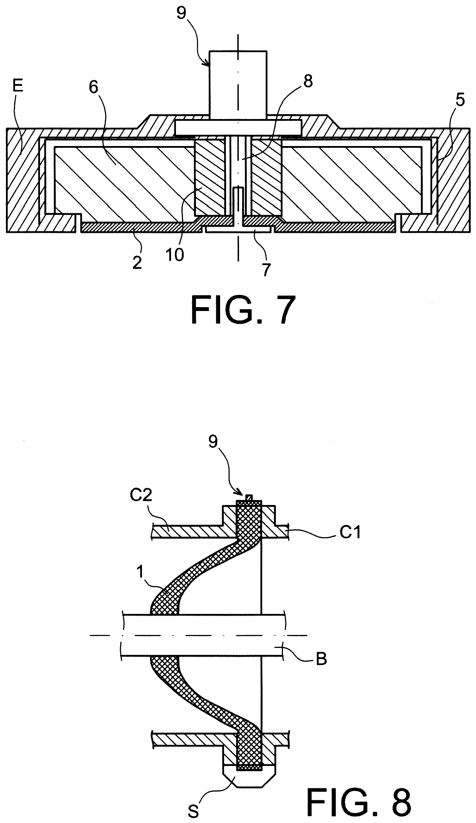

La figure 7 représente une vue en coupe transversale d'une deuxième variante de dispositif de connexion de dispositif de détection de décharge partielle conforme à la deuxième variante du premier mode de réalisation de l'invention.

Toutes choses égales par ailleurs, la deuxième variante du dispositif de connexion se différencie de la première variante par la présence d'une entretoise rigide électriquement isolante 10 qui entoure l'âme 8 du connecteur. Cette deuxième variante présente l'avantage de simplifier la forme de la pièce en élastomère au niveau du connecteur.

La figure 8 représente une vue en coupe longitudinale du matériel haute tension équipé d'un dispositif de détection de décharge partielle muni d'un dispositif de connexion selon l'invention.

La figure 8 illustre, à titre d'exemple non limitatif, une vue en coupe longitudinale du matériel haute tension dans le cas où le connecteur 9 fait face à un shunt S qui relie électriquement les deux parties C1, C2 du matériel haute tension. De façon générale, le signal recueilli par le connecteur 9 est transmis, via un câble de liaison (non représenté sur la figure), à un dispositif de lecture (non représenté sur la figure).

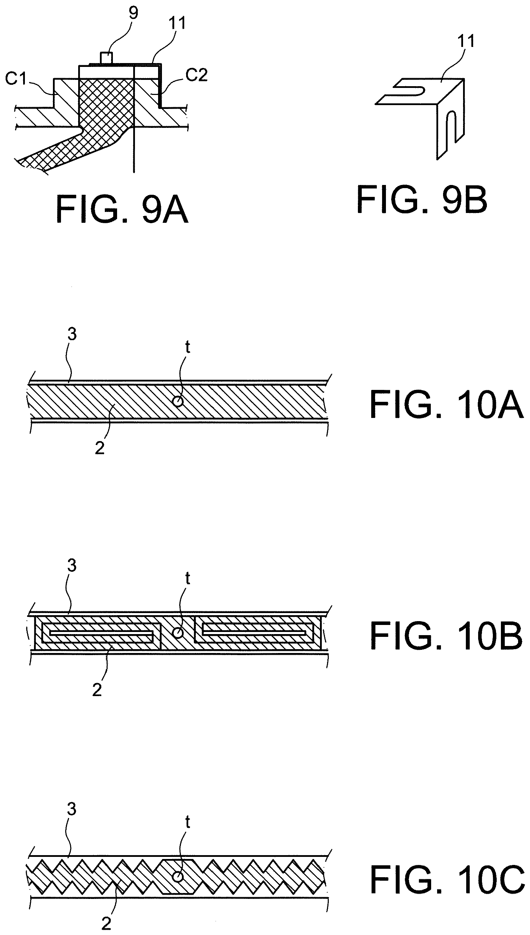

Selon un perfectionnement de l'invention, le connecteur 9 est maintenu sur le matériel haute tension à l'aide de brides. La figure 9A représente, à titre d'exemple non limitatif, une vue en coupe transversale d'un connecteur 9 maintenu sur le matériel haute tension à l'aide d'une bride 11 et la figure 9B représente une vue en perspective de la bride 11 représentée sur la figure 9A. Selon un autre mode de réalisation de l'invention (non représenté sur les figures), le connecteur 9 est maintenu, par exemple, par deux brides qui se font face.

Les figures 10A-10D représentent, à titre d'exemples non limitatifs, différents motifs de bandes métalliques utilisés pour la réalisation d'un dispositif de détection de décharge partielle conforme au premier mode de réalisation de l'invention.

La figure 10A représente un cas où la bande électriquement conductrice 2 est une bande pleine qui recouvre de façon homogène la bande de matériau électriquement isolant 3.

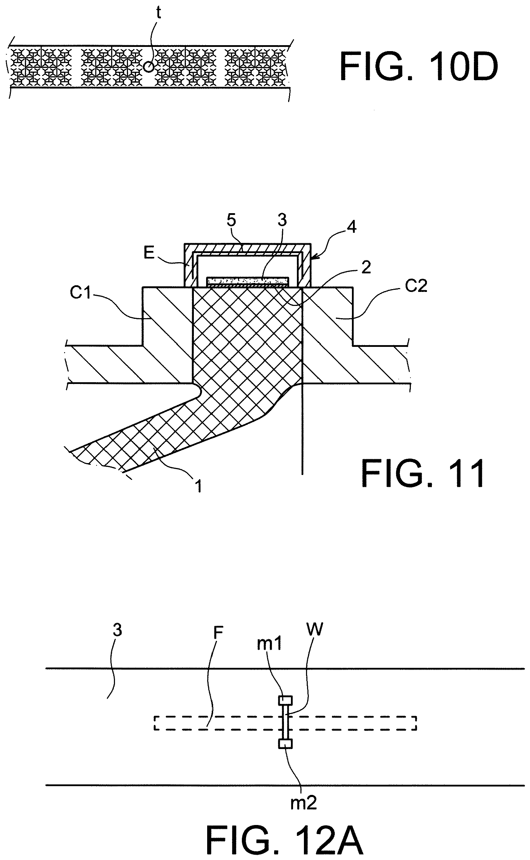

Les figures 10B, 10C et 10D représentent des cas où la bande électriquement conductrice 2 est une bande à motifs. Les motifs sont alors avantageusement choisis en fonction de la fréquence des signaux dont on souhaite privilégier la détection. La figure 10B représente un cas où le motif de la bande électriquement conductrice est un motif de type « à la grecque ». La figure 10C représente un cas où le motif de la bande électriquement conductrice est de type « à losanges répétitifs ». La figure 10D représente un cas où le motif de la bande électriquement conductrice a une géométrie fractale. De façon symbolique, le trou débouchant qui permet le passage de l'âme 8 du connecteur à travers les bandes 2 et 3 est représenté par la référence « t » sur les figures 10A-10D.

La figure 11 représente une vue en coupe longitudinale d'une troisième variante de dispositif de détection de décharge partielle conforme au premier mode de réalisation de l'invention.

Selon la troisième variante du premier mode de réalisation de l'invention, la pièce en élastomère prend appui sur le matériel haute tension, sans contact avec les bandes 2 et 3. La pièce en élastomère est formée de trois parois qui définissent une cavité, une première paroi étant sensiblement parallèle aux bandes 2 et 3, et les deux autres parois, situées de part et d'autre de la première paroi, étant sensiblement perpendiculaires à la première paroi. Les extrémités des deuxième et troisième parois prennent appui sur le matériel haute tension. Le blindage électrique est réalisé, par exemple, par une pièce électriquement conductrice 5 moulée dans la pièce en élastomère, ou par une poudre métallique dispersée dans la pièce en élastomère, ou par une peinture électriquement conductrice déposée sur les faces intérieures de la cavité définie par la pièce en élastomère.

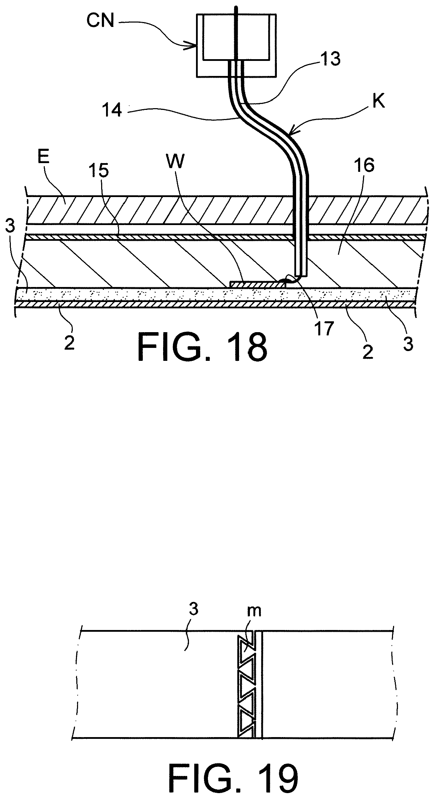

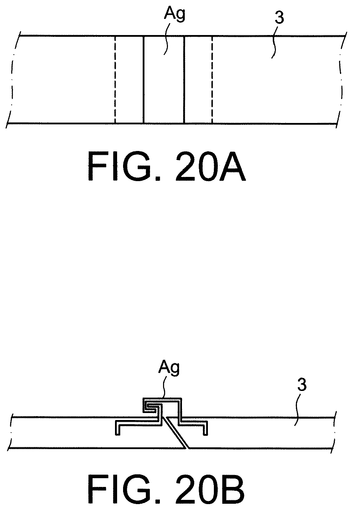

Le système d'attache de l'ensemble constitué par la bande électriquement conductrice 2 et la bande de matériau électriquement isolant 3 est alors indépendant du système d'attache de la pièce 4. Dans le cas où la bande électriquement conductrice 2 est une bande souple entièrement enroulée sur la surface de la pièce électriquement isolante, la fixation de la bande électriquement conductrice 2 et de la pièce 4 s'effectue par les moyens de fermeture décrits en référence aux figures 19 et 20A-20B. Dans le cas où la bande électriquement conductrice 2 ne recouvre qu'une partie de la surface de la pièce électriquement isolante, la fixation du dispositif de détection s'effectue par tout moyen connu en soi, par exemple des sangles. Sur la figure 11, la bande de matériau électriquement isolant est une bande diélectrique 3. L'invention s'applique également au cas où la bande de matériau électriquement isolant est une couche de mousse 6. Le connecteur qui prélève le signal de décharge partielle selon cette troisième variante du premier mode de réalisation de l'invention est conforme au connecteur décrit précédemment en référence aux figures 6-8 et 9A-9B. Selon le premier mode de réalisation de l'invention, comme cela a déjà été mentionné précédemment, la pièce de blindage électrique est avantageusement éloignée de la bande électriquement conductrice 2, par le biais de la pièce en élastomère E. Toutefois, l'invention concerne également le cas où la pièce de blindage électrique est constituée d'une couche métallique fixée sur la face de la bande de matériau électriquement isolant qui est située à l'opposé de la face sur laquelle est fixée la bande électriquement conductrice. Ce mode de réalisation de l'invention est particulièrement avantageux par sa simplicité de mise en œuvre.

Les figures 12A-12B représentent des antennes à fente(s) qui participent à un dispositif de détection conforme au deuxième mode de réalisation de l'invention.

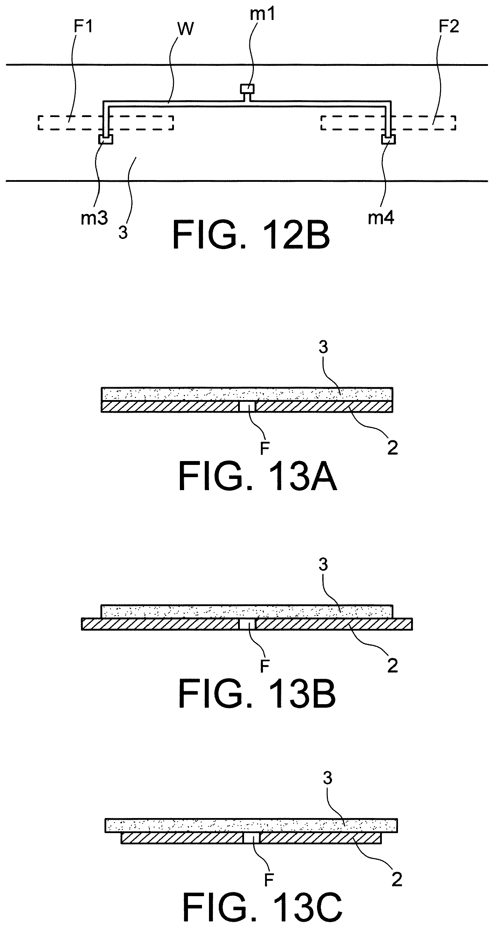

Les figures 12A et 12B sont des vues de dessus (côté couche diélectrique 3), d'une antenne munie d'une seule fente F (cf. figure 12A) et d'une antenne munie de deux fentes F1, F2 (cf. figure 12B). L'axe de chaque fente F, F1, F2 est sensiblement parallèle à l'axe de la couche métallique 2 et sensiblement centré par rapport à la largeur de la couche métallique 2.

Une pièce électriquement conductrice W, par exemple une pièce métallique, est fixée en surface de la bande de matériau électriquement isolant 3 et traverse localement la ou les fentes de l'antenne à fente(s). A l'aide de métallisations formées dans l'épaisseur de la bande de matériau électriquement isolant 3, la pièce électriquement conductrice W est électriquement reliée, sur un premier côté de la fente, à la bande électriquement conductrice 2 (métallisation m1 sur les figures 12A et 12B) et, sur le deuxième côté de la fente opposé au premier côté, à l'âme d'un connecteur qui prélève le signal détecté (métallisation m2 sur la figure 12A et métallisations m3 et m4 sur la figure 12B).

Les figures 13A-13C représentent des vues en coupe transversale de différentes variantes d'antennes à fentes telle que celles représentées sur les figures 12A et 12B. Les figures 13A-13C illustrent le fait que la largeur de la bande électriquement conductrice 2 peut indifféremment être supérieure, égale ou inférieure à la largeur de la couche diélectrique 3.

Sur les figures 12A-12B et 13A-13C, la bande de matériau électriquement isolant est une bande diélectrique 3. L'invention s'applique également au cas où la bande de matériau électriquement isolant est une couche de mousse 6.

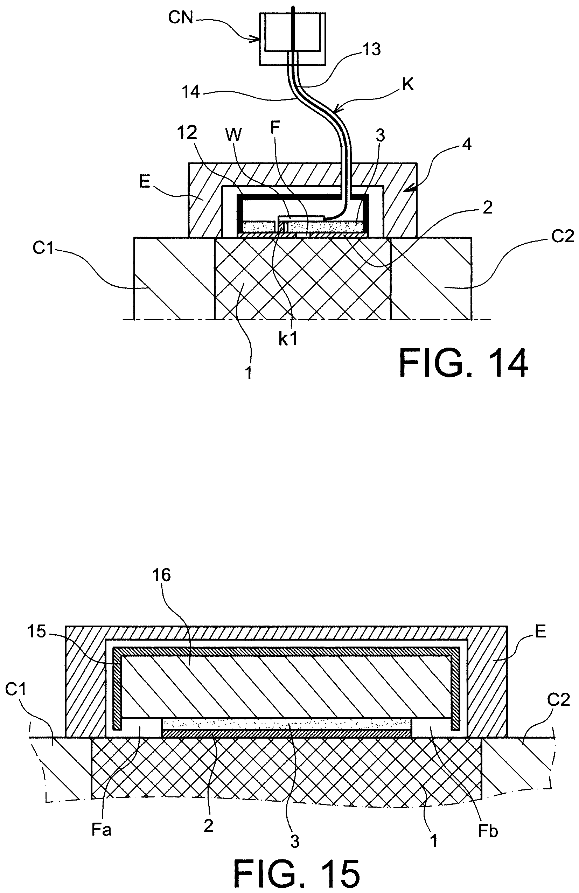

La figure 14 représente - au niveau d'un connecteur qui prélève le signal détecté - une vue en coupe d'un dispositif de détection de décharge partielle conforme au deuxième mode de réalisation de l'invention.

Comme pour le premier mode de réalisation de l'invention, la bande électriquement conductrice 2 est fixée sur tout ou partie de la circonférence définie par la surface extérieure de la pièce électriquement isolante. Une structure métallique 12 recouvre, à distance, la bande diélectrique 3 en assurant une continuité électrique avec les bords latéraux de la bande électriquement conductrice 2.

Sur un premier côté de la fente F, une première extrémité de la pièce électriquement conductrice W est reliée à la bande électriquement conductrice 2. A cette fin, la bande diélectrique 3 est perforée pour laisser passer une connexion électrique k1. Sur le deuxième côté de la fente F, la deuxième extrémité de la pièce électriquement conductrice W est reliée à l'âme 13 d'un câble coaxial K. Le câble coaxial K traverse la structure métallique 12 via un trou pratiqué dans ladite structure. Le blindage 14 du câble K est électriquement relié à la structure métallique 12 au niveau du trou. Par ailleurs, de façon connue en soi, le blindage 14 du câble coaxial est recouvert d'une gaine électriquement isolante (non représentée sur la figure, pour des raisons de commodité). De façon préférentielle, une pièce en élastomère E prend appui sur le matériel haute tension et recouvre les éléments 2, 3, W et 12.

Sur la figure 14, la bande de matériau électriquement isolant est une bande diélectrique 3. L'invention s'applique également au cas où la bande de matériau électriquement isolant est une bande de mousse 6.

De façon avantageuse, l'utilisation d'une antenne à fente(s) permet une amélioration sensible des performances du dispositif de détection.

La figure 15 représente une vue en coupe d'une antenne à double fentes qui participe à un dispositif de détection de décharge partielle conforme à un troisième mode de réalisation de l'invention.

L'antenne est constituée d'une bande électriquement conductrice 2 fixée sur une bande diélectrique 3 et d'une pièce électriquement conductrice de blindage 15 fixée sur une couche de mousse 16.

La pièce électriquement conductrice de blindage 15 a une section transversale en forme de U. La pièce électriquement conductrice de blindage 15 comprend une première paroi et deux parois latérales perpendiculaires à la première paroi. La couche de mousse 16 emplit un espace intérieur défini par les trois parois de la pièce électriquement conductrice 15, laissant saillir les parois latérales de la pièce électriquement conductrice 15. Les faces de la bande diélectrique 3 et de la couche de mousse 16 qui ne sont pas recouvertes de métallisation sont fixées l'une sur l'autre, la bande diélectrique 3 étant sensiblement centrée sur la couche de mousse 16. Il apparaît, de chaque côté de la bande électriquement conductrice 2, un espace entre l'extrémité en saillie de la paroi latérale de la pièce électriquement conductrice de blindage 15 et l'extrémité de la bande électriquement conductrice souple 2. Cet espace définit une fente Fa, Fb de l'antenne à double fentes. Sur l'exemple de la figure 15, la largeur de la bande électriquement conductrice 2 est égale à la largeur de la bande diélectrique 3. Il s'en suit que l'espace défini par chaque fente est vide de matière. Dans d'autres modes de réalisation de l'invention, cet espace peut être rempli par de la matière, par exemple de la mousse appartenant à la couche de mousse 16 ou du matériau diélectrique appartenant à une extension de largeur de la bande diélectrique 3.

La figure 16 est une vue de dessus, côté bande diélectrique 3, de l'antenne à double fentes représentée en figure 15. Une pièce électriquement conductrice W, fixée en surface de la bande diélectrique 3, est mise en contact électrique avec les parois latérales de la bande électriquement conductrice 2 et s'étend jusqu'à être mise en contact électrique avec les extrémités des parois latérales de la pièce électriquement conductrice 15. La pièce W est de forme sensiblement linéaire et son axe est sensiblement perpendiculaire à l'axe de la bande électriquement conductrice 2.

Les figures 17A et 17B représentent - au niveau d'un connecteur qui prélève le signal détecté - une vue en coupe transversale d'un dispositif de détection de décharge partielle conforme au troisième mode de réalisation de l'invention et la figure 18 représente - au niveau du même connecteur - une vue en coupe longitudinale du dispositif de détection.

La pièce électriquement conductrice W est mise en contact électrique avec les bords de la bande électriquement conductrice 2, par exemple via un pontage latéral soudé p (cf. Figures 17A et 17B). Un connecteur CN prélève le signal délivré par l'antenne à double fentes via un câble coaxial K dont l'âme 13 est électriquement reliée à la pièce électriquement conductrice W, par exemple par un point de soudure 17, et dont le blindage 14 est électriquement relié à la pièce électriquement conductrice 15 qui constitue ainsi une pièce de blindage du dispositif de détection (cf. figures 17A, 17B et 18).

A cette fin, le câble coaxial K traverse la pièce électriquement conductrice 15 et la bande de mousse 16 de telle sorte que son âme 13 atteigne la pièce électriquement conductrice W. De façon préférentielle, une pièce en élastomère E prend appui sur le matériel haute tension et recouvre l'ensemble des éléments 2, 3, W, 16 et 15.

Comme cela a déjà été mentionné précédemment, l'invention prévoit des moyens d'attache des différents types de bandes mentionnées ci-dessus (bande diélectrique 3, bande de mousse 6, bande en élastomère E).

Les figures 19 et 20A-20B représentent, à titre d'exemples non limitatifs, deux modes de fermeture différents de ces structures.

La figure 19 est une vue de dessus d'une bande diélectrique 3. La fermeture de cette bande s'effectue par des motifs de découpe complémentaires situés sur les deux extrémités de la bande. La géométrie des motifs définit des pleins (motifs m) à une première extrémité de la bande et des creux à l'extrémité opposée à la première extrémité, les pleins et les creux étant aptes à s'imbriquer les uns dans les autres de façon à maintenir la bande fermée.

Les figures 20A-20B sont respectivement une vue de dessus et une vue de côté d'un deuxième mode de fermeture de la bande diélectrique 3. Les deux extrémités de la bande sont ici fermées par une agrafe Ag.

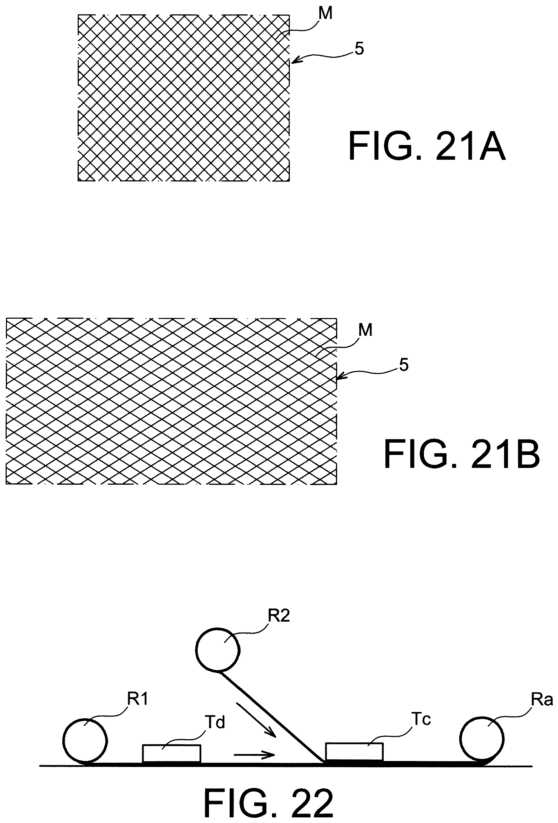

Les figures 21A et 21B représentent un exemple de pièce de blindage électrique utilisée dans le cadre de l'invention. Le blindage est réalisé par un maillage M électriquement conducteur apte à se déformer (maillage élastique de fils électriquement conducteurs ou maillage de bandes électriquement conductrices). A titre d'exemple non limitatif, les mailles sont orientées à 45°. La figure 21A représente le maillage M au repos et la figure 21B représente le maillage M étendu. De façon préférentielle, comme cela a été mentionné précédemment, le maillage est moulé dans une pièce en élastomère. L'orientation des mailles du blindage, non parallèle à l'axe de la bande électriquement conductrice 2, permet d'assurer un contact étroit entre l'antenne à bande et la pièce cylindrique électriquement isolante sur laquelle celle-ci est positionnée. Selon d'autres modes de réalisation de l'invention, le blindage est réalisé par une métallisation souple pleine moulée dans une pièce en élastomère, ou par une poudre métallique dispersée dans une pièce en élastomère, ou par une peinture électriquement conductrice déposée sur les faces d'une pièce en élastomère.

La figure 22 représente, à titre d'exemple non limitatif, un système apte à former un élément d'antenne conforme à l'un quelconque des trois modes de réalisation de l'invention décrits précédemment.

Une bande souple de cuivre munie de fente(s) ou non (bande électriquement conductrice 2) est enroulée sur un premier rouleau R1 et une bande souple de matériau électriquement isolant (bande diélectrique 3 ou bande de mousse 6) est enroulée sur un deuxième rouleau R2. Les rouleaux R1 et R2 sont mis en rotation de façon à superposer, sur un rouleau Ra, la bande souple de cuivre et la bande souple de matériau électriquement isolant. Avant la superposition des bandes, un dispositif de découpe Td découpe - si nécessaire - le cuivre selon les motifs souhaités. Dès lors que la bande de cuivre (découpée ou non) se superpose à la bande souple de matériau électriquement isolant, un dispositif de collage Tc colle la bande de cuivre et la bande souple de matériau électriquement isolant afin de constituer l'élément d'antenne du dispositif de détection.

## Revendications

1. Dispositif d'antenne pour la détection de décharge partielle de matériel haute tension isolé au gaz, le dispositif étant fixé, à l'extérieur du matériel haute tension, sur une face d'une pièce électriquement isolante (1) qui assure le maintien d'une barre haute tension (B) à l'intérieur du matériel haute tension, ladite face définissant, en surface du matériel haute tension, un cylindre de révolution, **caractérisé en ce qu'**il comprend :
- une bande électriquement conductrice (2) fixée sur une face d'une bande de matériau électriquement isolant (3, 6), la bande électriquement conductrice étant entièrement enroulée au contact exclusif de tout ou partie de ladite face de la pièce électriquement isolante, et
- une pièce de blindage électrique (5, 12, 15) fixée sur le matériel haute tension et qui est positionnée au-dessus de la bande de matériau électriquement isolant (3).

2. Dispositif selon la revendication 1, dans lequel :
- la bande électriquement conductrice (2) comprend au moins une fente (F, F1, F2) pratiquée dans toute l'épaisseur de la bande électriquement conductrice, la fente ayant un axe parallèle à un axe de la bande électriquement conductrice (2), l'axe de la fente étant sensiblement centré par rapport à la bande électriquement conductrice (2),
- la pièce de blindage électrique (12) prend appui sur la face de la pièce électriquement isolante (1), de part et d'autre de la bande électriquement conductrice (2), en étant mise en contact électrique avec des bords latéraux de la bande électriquement conductrice (2), et
- une pièce électriquement conductrice (W) est fixée, à la verticale de la fente, en surface de la bande faite de matériau électriquement isolant (3, 6), une première extrémité de la pièce électriquement conductrice (W), située sur un premier côté de la fente, étant électriquement reliée à une âme (13) de câble électrique coaxial (K) dont un blindage (14) est électriquement relié, d'une part, à la bande électriquement conductrice (2) via un premier trou pratiqué dans la bande faite de matériau électriquement isolant (3) et, d'autre part, à la pièce de blindage électrique (12) via un trou pratiqué dans la pièce de blindage électrique et une deuxième extrémité de la pièce électriquement conductrice (W), située sur un deuxième côté de la fente, opposé au premier côté, étant électriquement reliée à la bande électriquement conductrice (2) via un deuxième trou pratiqué dans la bande faite de matériau électriquement isolant.

3. Dispositif selon la revendication 2, dans lequel une pièce en élastomère (E) entoure la pièce de blindage électrique (12) en prenant appui sur le matériel haute tension, de part et d'autre de la pièce de blindage électrique (12), un trou étant pratiqué dans la pièce en élastomère pour laisser passer le câble électrique coaxial (K) .

4. Dispositif selon la revendication 1, dans lequel la pièce de blindage électrique (15) est fixée sur une couche de mousse (16), la pièce de blindage électrique (15) ayant une section transversale en forme de U et comprenant une première paroi et deux parois latérales perpendiculaires à la première paroi, la couche de mousse (16) emplissant un espace intérieur défini par les trois parois de la pièce de blindage électrique (15), laissant saillir les parois latérales de la pièce de blindage électrique (15), la face de la bande de matériau électriquement isolant (3) et la face de la couche de mousse (16) qui ne sont pas recouvertes de métallisation étant fixées l'une sur l'autre, la bande de matériau électriquement isolant (3) étant sensiblement centrée sur la couche de mousse (16), une largeur de la couche de mousse (16) étant supérieure à une largeur de la bande de matériau électriquement isolant (3) de telle sorte qu'il apparaît, de chaque côté de la bande électriquement conductrice (2), un espace entre l'extrémité en saillie de la paroi latérale de la pièce de blindage électrique (15) et l'extrémité de la bande électriquement conductrice (2), cet espace définissant une fente (Fa, Fb), et dans lequel une pièce électriquement conductrice (W) fixée en surface de la bande de matériau électriquement isolant (3, 6) est mise en contact électrique avec les bords de la bande électriquement conductrice (2) et s'étend, de part et d'autre de la bande électriquement conductrice, jusqu'à être mise en contact électrique avec les parois latérales de la pièce de blindage électrique (15), une âme (13) de câble coaxial (K) dont un blindage (14) est électriquement relié à la pièce de blindage électrique (15) via un trou pratiqué dans la pièce de blindage électrique (15) étant mise en contact avec la pièce électriquement conductrice (W).

5. Dispositif selon la revendication 4, dans lequel la largeur de la bande de matériau électriquement isolant (3) est identique ou supérieure à la largeur de la bande électriquement conductrice (2).

6. Dispositif selon la revendication 5, dans lequel de la mousse emplit l'espace entre l'extrémité en saillie de la paroi latérale de la pièce de blindage électrique (15) et l'extrémité de la bande électriquement conductrice (2).

7. Dispositif selon la revendication 1, dans lequel la pièce de blindage électrique (5) est une pièce électriquement conductrice moulée dans une pièce en élastomère (E) qui prend appui sur le matériel haute tension, la pièce en élastomère définissant une cavité (KA) dans laquelle la bande faite de matériau électriquement isolant (3, 6) est placée.

8. Dispositif selon la revendication 7, dans lequel la pièce de blindage électrique (5) est un maillage élastique de fils électriquement conducteurs ou de bandes électriquement conductrices, le maillage étant apte à s'allonger dans une direction parallèle à l'axe de la bande électriquement conductrice (2).

9. Dispositif selon la revendication 1, dans lequel la pièce de blindage électrique (5) est constituée :
- soit d'une poudre métallique dispersée dans une pièce en élastomère qui prend appui sur le matériel haute tension, la pièce en élastomère définissant une cavité (KA) dans laquelle la bande souple de matériau électriquement isolant (3, 6) est placée,
- soit d'une peinture électriquement conductrice déposée sur une pièce en élastomère qui prend appui sur le matériel haute tension, la pièce en élastomère définissant une cavité dans laquelle la bande souple de matériau électriquement isolant (3, 6) est placée, la peinture électriquement conductrice étant déposée sur les faces intérieures de la cavité,
- soit d'une bande électriquement conductrice supplémentaire qui recouvre une face de la bande de matériau électriquement isolant (3) opposée à la face sur laquelle est fixée la bande électriquement conductrice (2) .

10. Dispositif selon la revendication 7, prise seule ou en combinaison avec la revendication 8, ou la revendication 9, dans lequel un connecteur électrique (9) comprend une âme (8) qui est électriquement reliée à la bande électriquement conductrice (2) via une sonde de liaison (7) qui est au contact de la bande électriquement conductrice, l'âme (8) du connecteur électrique traversant la bande de matériau électriquement isolant (3) via un trou débouchant pratiqué dans la bande de matériau électriquement isolant.

11. Dispositif selon la revendication 10, dans lequel le trou débouchant est empli par :
- soit une entretoise électriquement isolante qui entoure l'âme (8) du connecteur,
- soit, lorsque la pièce de blindage électrique (5) n'est pas constituée d'une bande électriquement conductrice supplémentaire qui recouvre une face de la bande de matériau électriquement isolant (3) opposée à la face sur laquelle est fixée la bande électriquement conductrice (2), par de l'élastomère (E) de la pièce en élastomère qui entoure l'âme (8) du connecteur.

12. Dispositif selon l'une quelconque des revendications précédentes, dans lequel la bande électriquement conductrice (2) comprend des motifs aptes à privilégier une détection d'un signal de décharge partielle ayant une bande de fréquence donnée.

13. Dispositif selon l'une quelconque des revendications précédentes, dans lequel le matériau électriquement isolant est choisi parmi du mylar, une mousse, et un polyuréthane.

14. Dispositif selon l'une quelconque des revendications précédentes, dans lequel la bande électriquement conductrice (2) et la bande de matériau électriquement isolant (3) sont des bandes souples,
et dans lequel la longueur de la bande électriquement conductrice (2) est égale à la circonférence du cylindre de révolution défini par la face de la pièce électriquement isolante et des moyens de fermeture (Ag, m) maintiennent la bande de matériau électriquement isolant (3, 6) et la pièce de blindage électrique (5) en surface du matériel haute tension.

15. Poste électrique haute tension isolé au gaz équipé d'au moins un dispositif de détection de décharge partielle, **caractérisé en ce que** le dispositif de détection de décharge partielle est un dispositif conforme à l'une quelconque des revendications 1 à 14.

## Patentansprüche

1. Antennenvorrichtung zum Detektieren von Teilentladung von mit Gas isolierter Hochspannungsausrüstung, wobei die Vorrichtung an der Außenseite der Hochspannungsausrüstung auf einer Fläche eines elektrisch isolierenden Teils (1) fixiert ist, das das Halten eines Hochspannungsstabs (B) im Inneren der Hochspannungsausrüstung gewährleistet, wobei die Fläche an der Oberfläche der Hochspannungsausrüstung einen Drehzylinder definiert, **dadurch gekennzeichnet, dass** er Folgendes umfasst:
- einen elektrisch leitfähigen Streifen (2), der auf einer Fläche eines elektrisch isolierenden Materialstreifens (3, 6) fixiert ist, wobei der elektrisch leitfähige Streifen vollständig in exklusivem Kontakt der ganzen oder eines Teils der Fläche des elektrisch isolierenden Teils (1) aufgewickelt ist, und
- ein Teil zur elektrischen Abschirmung (5, 12, 15), das auf der Hochspannungsausrüstung fixiert ist, und das oberhalb des elektrisch isolierenden Materialstreifens (3) positioniert ist.

2. Vorrichtung nach Anspruch 1, wobei:
- der elektrisch leitfähige Streifen (2) mindestens einen in der ganzen Dicke des elektrisch leitfähigen Streifens ausgeführten Schlitz (F, F1, F2) umfasst, wobei der Schlitz eine Achse parallel zu einer Achse des elektrisch leitfähigen Streifens (2) aufweist, wobei die Achse des Schlitzes bezogen auf den elektrisch leitfähigen Streifen (2) im Wesentlichen zentriert ist,
- das Teil zur elektrischen Abschirmung (12) auf der Fläche des elektrisch isolierenden Teils (1) auf beiden Seiten des elektrisch leitfähigen Streifens (2) anliegt, indem es elektrisch mit seitlichen Rändern des elektrisch leitfähigen Streifens (2) in Kontakt gebracht wird, und
- ein elektrisch leitfähiges Teil (W) an der Vertikalen des Schlitzes an der Oberfläche des aus elektrisch isolierendem Material hergestellten Streifens (3, 6) fixiert ist, wobei ein erstes Ende des elektrisch leitfähigen Teils (W), das sich auf einer ersten Seite des Schlitzes befindet, elektrisch mit einem Leiter (13) eines elektrischen Koaxialkabels (K) verbunden ist, von dem eine Abschirmung (14) einerseits durch ein erstes in dem aus elektrisch isolierendem Material hergestellten Streifen (3) ausgeführtes Loch mit dem elektrisch leitfähigen Streifen (2), und andererseits durch ein in dem Teil elektrischer Abschirmung ausgeführtes Loch mit dem Teil elektrischer Abschirmung (12) elektrisch verbunden ist, und ein zweites Ende des elektrisch leitfähigen Teils (W), das sich auf einer zweiten Seite des Schlitzes der ersten Seite gegenüberliegend befindet, elektrisch durch ein zweites Loch, das in dem aus elektrisch isolierendem Material hergestellten Streifen ausgeführt ist, mit dem elektrisch leitfähigen Streifen (2) verbunden ist.

3. Vorrichtung nach Anspruch 2, wobei ein Teil aus Elastomer (E) das Teil zur elektrischen Abschirmung (12) umgibt und an der Hochspannungsausrüstung anliegt, wobei auf beiden Seiten des Teils zur elektrischen Abschirmung (12) ein Loch in dem Teil aus Elastomer ausgeführt ist, um das elektrische Koaxialkabel (K) hindurchgehen zu lassen.

4. Vorrichtung nach Anspruch 1, wobei das Teil zur elektrischen Abschirmung (15) auf einer Schaumschicht (16) fixiert ist, das Teil zur elektrischen Abschirmung (15) einen Querschnitt in U-Form aufweist und eine erste Wand und zwei seitliche, zur ersten Wand senkrechte Wände umfasst, die Schaumschicht (16) einen durch die drei Wände des Teils zur elektrischen Abschirmung (15) definierten Innenraum auffüllt, die die Seitenwände des Teils zur elektrischen Abschirmung (15) hervorstehen lässt, wobei die Fläche des elektrisch isolierenden Materialstreifens (3) und die Fläche der Schaumschicht (16), die nicht von Metallisierung bedeckt sind, aufeinander fixiert sind, wobei der elektrisch isolierende Materialstreifen (3) im Wesentlichen auf der Schaumschicht (16) zentriert ist, eine Breite der Schaumschicht (16) größer als eine Breite des elektrisch isolierenden Materialstreifens (3) ist, sodass von jeder Seite des elektrisch leitfähigen Streifens (2) ein Raum zwischen dem von der Seitenwand des Teils zur elektrischen Abschirmung (15) hervorstehenden Ende und dem Ende des elektrisch leitfähigen Streifens (2) erscheint, wobei dieser Raum einen Schlitz (Fa, Fb) definiert, und wobei ein an der Oberfläche des elektrisch isolierenden Materialstreifens (3, 6) fixiertes elektrisch leitfähiges Teil (W) mit den Rändern des elektrisch leitfähigen Streifens (2) in Kontakt gebracht wird und sich auf beiden Seiten des elektrisch leitfähigen Streifens erstreckt, bis es mit den Seitenwänden des Teils zur elektrischen Abschirmung (15) in elektrischen Kontakt gebracht wird, wobei ein Leiter (13) des Koaxialkabels (K), von dem eine Abschirmung (14) elektrisch mit dem Teil zur elektrischen Abschirmung (15) über ein in dem Teil zur elektrischen Abschirmung (15) ausgeführtes Loch, das mit dem elektrisch leitfähigen Teil (W) in Kontakt gebracht wurde, elektrisch verbunden ist.

5. Vorrichtung nach Anspruch 4, wobei die Breite des elektrisch isolierenden Materialstreifens (3) identisch oder größer ist als die Breite des elektrisch leitfähigen Streifens (2).

6. Vorrichtung nach Anspruch 5, wobei der Schaum den Raum zwischen dem hervorstehenden Ende der Seitenwand des Teils zur elektrischen Abschirmung (15) und dem Ende des elektrisch leitfähigen Streifens (2) auffüllt.

7. Vorrichtung nach Anspruch 1, wobei das Teil zur elektrischen Abschirmung (5) ein in einem Teil aus Elastomer (E) geformtes elektrisch leitfähiges Teil ist, das gegen die Hochspannungsausrüstung anliegt, wobei das Teil aus Elastomer einen Hohlraum (K) definiert, in den der aus elektrisch isolierendem Material hergestellte Streifen (3, 6) platziert wird.

8. Vorrichtung nach Anspruch 7, wobei das Teil zur elektrischen Abschirmung (5) ein elastisches Geflecht aus elektrisch leitfähigen Drähten oder elektrisch leitfähiger Streifen ist, wobei das Geflecht in der Lage ist, sich in einer Richtung parallel zur Achse des elektrisch leitfähigen Streifens (2) zu verlängern.

9. Vorrichtung nach Anspruch 1, wobei das Teil zur elektrischen Abschirmung (5) aus Folgendem besteht:
- entweder einem in einem Teil aus Elastomer dispergierten metallischem Pulver, das gegen die Hochspannungsausrüstung anliegt, wobei das Teil aus Elastomer einen Hohlraum (K) definiert, in den der flexible elektrisch isolierende Materialstreifen (3, 6) platziert wird,
- oder einer auf einem Teil aus Elastomer, das gegen die Hochspannungsausrüstung anliegt, abgeschiedenen elektrisch leitfähigen Anstrichfarbe, wobei das Teil aus Elastomer einen Hohlraum definiert, in den der flexible elektrisch isolierende Materialstreifen (3, 6) platziert wird, wobei die elektrisch leitfähige Anstrichfarbe auf den Innenflächen des Hohlraums abgeschieden wird,
- oder aus einem ergänzenden elektrisch leitfähigen Streifen, der eine Fläche des elektrisch isolierendem Materialstreifens (3) bedeckt, der Fläche gegenüberliegend, auf welcher der elektrisch leitfähige Streifen (2) fixiert ist.

10. Vorrichtung nach Anspruch 7, einzeln genommen oder in Kombination mit Anspruch 8 oder Anspruch 9, wobei ein elektrisches Verbindungsstück (9) einen Leiter (8) umfasst, die elektrisch mit dem elektrisch leitfähigen Streifen (2) über eine Verbindungssonde (7) verbunden ist, die mit dem elektrisch leitfähigen Streifen in Kontakt steht, wobei der Leiter (8) des elektrischen Verbindungsstücks den elektrisch leitfähigen Materialstreifen (3) durch ein Durchgangsloch durchquert, das in dem elektrisch isolierendem Materialstreifen ausgeführt ist.

11. Vorrichtung nach Anspruch 10, wobei das Durchgangsloch gefüllt ist mit:
- entweder einem elektrisch isolierenden Zwischenstück, das den Leiter (8) des Verbindungsstücks umgibt,
- oder, wenn das Teil zur elektrischen Abschirmung (5) nicht aus einem ergänzenden elektrisch leitfähigen Streifen besteht, der eine Fläche des elektrisch isolierenden Materialstreifens (3) bedeckt, die der Fläche gegenüberliegt, auf der der elektrisch leitfähige Streifen (2) fixiert ist, aus dem Elastomer (E) des Teils aus Elastomer, das den Leiter (8) des Verbindungsstücks umgibt.

12. Vorrichtung nach einem der vorstehenden Ansprüche, wobei der elektrisch leitfähige Streifen (2) Motive umfasst, die in der Lage sind, eine Detektion eines Teilentladungssignals, das ein gegebenes Frequenzband aufweist, zu bevorzugen.

13. Vorrichtung nach einem der vorstehenden Ansprüche, wobei das elektrisch isolierende Material ausgewählt ist aus Mylar, einem Schaum und einem Polyurethan.

14. Vorrichtung nach einem der vorstehenden Ansprüche, wobei der elektrisch leitfähige Streifen (2) und der elektrisch isolierende Materialstreifen (3) flexible Streifen sind, und wobei die Länge des elektrisch leitfähigen Streifens (2) gleich dem Umfang des durch die Fläche des elektrisch isolierenden Teils definierten Drehzylinders ist und die Verschlussmittel (Ag, m) den elektrisch isolierenden Materialstreifen (3, 6) und das Teil zur elektrischen Abschirmung (5) an der Oberfläche der Hochspannungsausrüstung halten.

15. Elektrischer mit Gas isolierter Hochspannungsposten, ausgestattet mit mindestens einer Detektionsvorrichtung zur Teilentladung, **dadurch gekennzeichnet, dass** die Detektionsvorrichtung zur Teilentladung eine Vorrichtung konform mit einem der Ansprüche 1 bis 14 ist.

## Claims

1. Antenna device for detection of partial discharge of gas-insulated high voltage equipment, the device being fixed to the exterior of the high voltage equipment on a face of an electrically insulating part (1) that holds a high voltage bar (B) inside the high voltage equipment, said face defining a cylinder of revolution on the surface of the high voltage equipment, **characterised in that** it comprises:
- an electrically conducting strip (2) fixed onto a face of a strip of electrically insulating material (3, 6), the electrically conducting strip being entirely wound in exclusive contact with all or part of said electrically insulating part (1), and
- an electric shielding part (5, 12, 15) fixed on the high voltage equipment and that is positioned above the strip of electrically insulating material (3).

2. Device according to claim 1, wherein:
- the electrically conducting strip (2) comprises at least one slot (F, F1, F2) formed through the entire thickness of the electrically conducting strip, the slot having an axis parallel to an axis of the electrically conducting strip (2), the axis of the slot being approximately centred relative to the electrically conducting strip (2),
- the electrical shielding part (12) bears on the face of the electrically insulating part (1), on each side of the electrically conducting strip (2), while being put into electrical contact with the side edges of the electrically conducting strip (2), and
- an electrically conducting part (W) is fixed vertically in line with the slit, on the surface of the strip made of an electrically insulating material (3, 6), a first end of the electrically conducting part (W), located on a first side of the slit, being electrically connected to a core (13) of a coaxial electrical cable (K) the shielding (14) of which is electrically connected firstly to the electrically conducting strip (2) through a first hole formed in the strip made of electrically insulating material (3), and secondly to the electrical shielding part (12) through a hole formed in the electrical shielding part and a second end of the electrically conducting part (W) located on a second side of the slit, opposite the first side, being electrically connected to the electrically conducting strip (2) through a second hole formed in the strip made of an electrically insulating material.

3. Device according to claim 2, wherein an elastomer part (E) surrounds the electrical shielding part (12) bearing on the high voltage equipment, on each side of the equipment shielding part (12), a second hole being formed in the elastomer part to allow the coaxial electrical cable (K) to pass through.

4. Device according to claim 1, wherein the electrical shielding part (15) is fixed on a foam layer (16), the electrical shielding part (15) having a U-shaped cross-section and comprising a first wall and two side walls perpendicular to the first wall, the foam layer (16) filling an internal space defined by the three walls of the electrical shielding part (15), allowing projection of the lateral walls of the electrical shielding part (15), the face of the strip of electrically insulating material (3) and the face of the foam layer (16) that are not covered by metallisation being fixed to each other, the strip of electrically insulating material (3) being centred approximately on the foam layer (16), a width of the foam layer (16) being larger than a width of the strip of electrically insulating material (3) such that there is space formed on each side of the electrically conducting strip (2), between the projecting end of the side wall of the electrical shielding part (15) and the end of the electrically conducting strip (2), this space defining a slot (Fa, Fb), and wherein an electrically conducting part (W) fixed to the surface of the strip of electrically insulating material (3, 6) is brought into electrical contact with the edges of the electrically conducting strip (2) and extends on each side of the electrically conducting strip, until coming into electrical contact with the side walls of the electrical shielding part (15), a core (13) of the coaxial cable (K) of which shielding (14) is electrically connected to the electrical shielding part (15) through a hole formed in the electrical shielding part (15) being put into electrical contact with the electrically conducting part (W).

5. Device according to claim 4, wherein the width of the strip of electrically insulating material (3) is the same as or is larger than the width of the electrically conducting strip (2).

6. Device according to claim 5, wherein foam fills the space between the projecting end of the side wall of the electrical shielding part (15) and the end of the electrically conducting strip (2).

7. Device according to claim 1, wherein the electrical shielding part (5) is an electrically conducting part moulded in an elastomer part (E) that bears on the high voltage equipment, the elastomer part defining a cavity (K) in which the part made of an electrically insulating material (3, 6) is placed.

8. Device according to claim 7, wherein the electrical shielding part (5) is an elastic mesh of electrically conducting wires or electrically conducting strips, the mesh being extendible along a direction parallel to the axis of the electrically conducting strip (2).

9. Device according to claim 1, wherein the electrical shielding part (5) is composed of:
- either a metallic powder dispersed in an elastomer part that bears on the high voltage equipment, the elastomer part defining a cavity (K) in which the flexible strip of electrically insulating material (3, 6) is placed,
- or an electrically conducting paint deposited on an elastomer part that bears on the high voltage equipment, the elastomer part defining a cavity in which the flexible strip of electrically insulating material (3, 6) is placed, the electrically conducting paint being deposited on the internal faces of the cavity,
- or an additional electrically conducting strip that covers one face of the strip of electrically insulating material (3) opposite the face on which the electrically conducting strip (2) is fixed.

10. Device according to claim 7, alone or in combination with claim 8, or according to claim 9, wherein an electrical connector (9) comprises a core (8) that is electrically connected to the electrically conducting strip (2) via a connecting probe (7) that is in contact with the electrical conducting strip, the core (8) of the electrical connector passing through the strip of electrically insulating material (3) via a through hole formed in the strip of electrically insulating material.

11. Device according to claim 10, wherein the through hole is filled with:
- either an electrically insulating strut that surrounds the core (8) of the connector,
- or, when the electrical shielding part (5) is not composed of an additional electrically conducting strip that covers a face of the strip of electrically insulating material (3) opposite the face on which the electrically conducting strip (2) is fixed by the elastomer (E) of the elastomer part that surrounds the core (8) of the connector.

12. Device according to any one of the previous claims, wherein the electrically conducting strip (2) comprises patterns that give priority to detection of a partial discharge signal with a given frequency band.

13. Device according to any one of the previous claims, wherein the electrically insulating material is chosen from among mylar, a foam and a polyurethane.

14. Device according to any one of the previous claims, wherein the electrically conducting strip (2) and the strip of electrically insulating material (3) are flexible strips,
and wherein the length of the electrically insulating strip (2) is equal to the circumference of the cylinder of revolution defined by the face of the electrically insulating part and closing means (Ag, m) hold the strip of electrically insulating material (3, 6) and the electrical shielding part (5) on the surface of the high voltage equipment.

15. Gas-insulated high voltage electrical substation equipped with at least one partial discharge detection device, **characterised in that** the partial discharge detection device is a device according to any one of claims 1 to 14.
